# EUROPEAN PATENT APPLICATION

(11) **EP 2 851 945 A1**
(43) Date of publication of application: **25.03.2015**
(21) Application number: 12876775.3
(22) Date of filing: 17.05.2012
(51) Int. Cl.: H01L 23/28, H01L 25/04, H01L 25/18, H05K 7/04

(54) **SEMICONDUCTOR MODULE AND SEMICONDUCTOR DEVICE**

(71) Applicant: Mitsubishi Electric Corporation, Tokyo 100-8310 (JP)
(72) Inventor: KAWAUCHI, Yuki, Tokyo 100-8310 (JP); KITAI, Kiyofumi, Tokyo 100-8310 (JP)
(74) Representative: Hoffmann Eitle
(86) International application number: PCT/JP2012/062683
(87) International publication number: WO 2013/171882

(57) **Abstract**

To obtain a semiconductor module that can fix itself onto a fixing object while enabling further miniaturization and alleviating the load applied to a molded resin, a semiconductor module 7 includes a semiconductor element 1; a placing frame 2 on which the semiconductor element 1 is placed; a control substrate 5 onto which a control component 14 for controlling the semiconductor element 1 is mounted; and a molded resin 8 in which the semiconductor element 1, the placing frame 2, and the control substrate 5 are integrally molded. Fixing bases 5a exposed from the molded resin 8 are provided on the control substrate 5 for fixing the semiconductor module 7 onto a fixing object.

## Description

### Field

The present invention relates to a semiconductor module in which a control substrate, along with a semiconductor element, are encapsulated in molded resin and relates to a semiconductor device in which the semiconductor module is used.

### Background

Semiconductor modules that are made more compact in size by encapsulating a control substrate along with a semiconductor element in molded resin are in conventional use (see, for example, Patent Literature 1). Such semiconductor modules are often employed as semiconductor devices whose chassis are used as fixing objects. In order to fix the semiconductor modules onto the chassis, threaded holes are formed through the molded resin.

### Citation List

### Patent Literature

Patent Literature 1: Japanese Patent Application Laid-open No. 2006-54245

### Summary

### Technical Problem

The threaded holes formed through the molded resin, however, need to be of a size sufficient for fixing. Thus, some portion is left spare to form threaded holes in the molded resin, which limits the miniaturization of the semiconductor modules. In addition, loads are applied to the molded resin for a long period of time if screw-fixing occurs through the molded resin; therefore, it becomes necessary to address the deformations caused by creep phenomena.

The present invention is made in view of the above, and the object is to provide a semiconductor module with lower loads applied to the molded resin and with the semiconductor module's size further miniaturized, while enabling fixing to the fixing objects.

### Solution to Problem

To solve the above problems and achieve the object, the present invention relates to a semiconductor module that includes: a semiconductor element; a placing frame on which the semiconductor element is placed; a control substrate onto which a control component for controlling the semiconductor element is mounted; and a molded resin in which the semiconductor element, the placing frame, and the control substrate are integrally molded. A fixing base exposed from the molded resin is provided on the control substrate for fixing the semiconductor module onto a fixing object.

### Advantageous Effects of Invention

The semiconductor module according to the present invention includes a control substrate provided with a fixing substrate so that loads applied to the molded resin are lessened and the size is further miniaturized while being able to fix the semiconductor module to the objects to which it is to be fixed. This is an advantageous effect.

### Brief Description of Drawings

FIG. 1 is a plan view illustrating an approximate configuration of a semiconductor device according to a first Embodiment of the present invention.
FIG. 2 is a cross-sectional view taken along the line A-A illustrated in FIG. 1.

### Description of Embodiments

A semiconductor module and a semiconductor device according to a first embodiment of the present invention are described below in detail with reference to the accompanying drawings. The present invention is not limited to this embodiment.

### First Embodiment

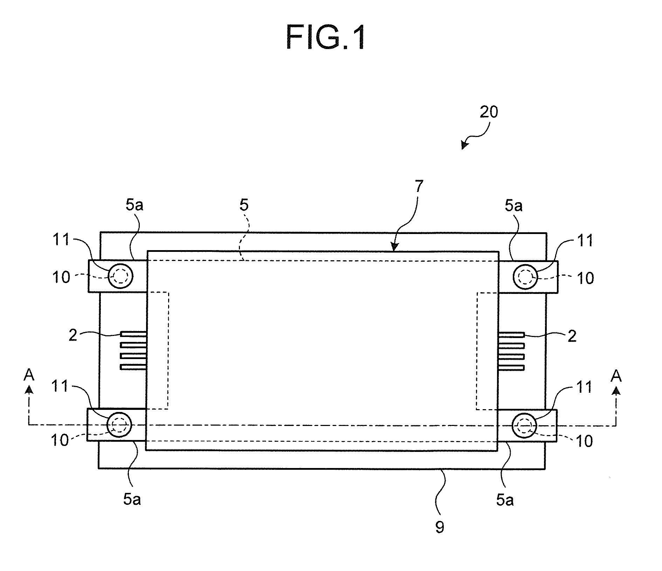

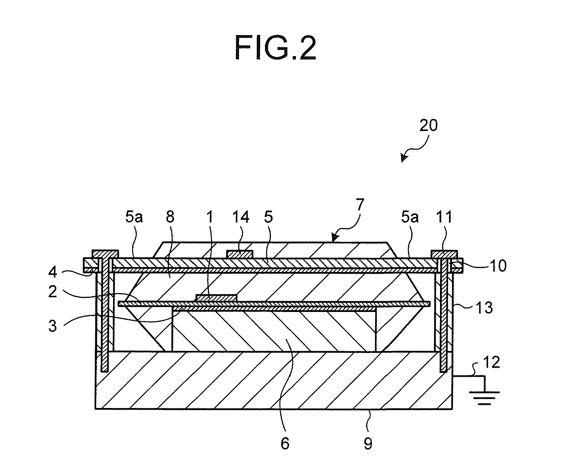

FIG. 1 is a plan view illustrating an approximate configuration of a semiconductor device according to a first embodiment of the present invention. FIG. 2 is a cross-sectional view taken along the line A-A illustrated in FIG. 1. A semiconductor device 20 includes a semiconductor module 7 and a chassis (a fixing object) 9; and the semiconductor module 7 is fixed onto the chassis 9. As illustrated in FIG. 2, the semiconductor module 7 includes a semiconductor element 1, a lead frame (a placing frame) 2, an insulating sheet 3, a shield plate 4, a control substrate 5, a heat-dissipating component 6, and molded resin 8.

The semiconductor element 1 is placed on the lead frame 2. Parts of the lead frame 2 are exposed from the molded resin 8 and are connected to, for example, external wiring (not illustrated). The semiconductor element 1 is connected to the external wiring via the lead frame 2. Note that an object, on which the semiconductor element 1 is placed, is not limited to the lead frame 2 connected to the external wiring, but may be any other component so long as the object is a component that ensures there is space for the semiconductor element 1 to be placed.

The heat-dissipating component 6 is provided below the lead frame 2 with the insulating sheet 3 sandwiched therebetween. The heat-dissipating component 6 is configured from a component having high thermal conductivity, such as a metal. The control substrate 5 is provided above the semiconductor element 1 and the lead frame 2. A control component 14 for controlling the semiconductor element is mounted on the control substrate 5. The shield plate 4 is provided between the control substrate 5 and the semiconductor element 1. In the present embodiment, a solid pattern is formed on the surface of the control substrate 5 on a side of the semiconductor element 1 and functions as the shield plate 4.

The molded resin 8 is formed from molding resin such that it covers the semiconductor element 1, the lead frame 2, the insulating sheet 3, the shield plate 4, the control substrate 5, and the heat-dissipating component 6, and it constitutes the outer frame of the semiconductor module 7. The molded resin 8 is provided such that one surface of the heat-dissipating component is exposed at the bottom surface of the semiconductor module 7.

The control substrate 5 is formed such that parts of the control substrate 5 are exposed from the semiconductor module 7, and the exposed parts serve as fixing bases 5a for fixing the semiconductor module 7 onto the chassis 9. In the present embodiment, four fixing bases 5a are provided as an example, but the number is not limited to this example.

Threaded holes 10 are formed through the fixing bases 5a. The semiconductor module 7 is fixed onto the chassis 9 with screws 11 through the threaded holes 10 formed through the fixing bases 5a. In order for the semiconductor module 7 to be securely fixed onto the chassis 9, the fixing bases 5a are provided so as to be exposed from both one side and another side that is across the molded resin 8.

As illustrated in FIG. 2, the semiconductor module 7 is fixed to the chassis 9 such that the bottom surface thereof securely contacts the chassis 9. This allows the heat-dissipating component 6 exposed from the bottom surface of the semiconductor module 7 to securely contact the chassis 9. A spacer 13 may be provided between the fixing bases 5a of the control substrate 5 and the chassis 9. The spacer 13 may be integrally molded with the chassis 9. The chassis 9 is formed of metal such as aluminum. The chassis 9 is connected to a ground 12.

As described above, the semiconductor module 7 securely contacts the chassis 9 so that the heat generated by the semiconductor element 1 while switching can be dissipated through the chassis 9. In addition, since the threaded holes 10 for fixing the semiconductor module 7 to the chassis 9 with the screws 11 are not formed through the molded resin 8 but formed through the fixing bases 5a of the control substrate 5, the threaded holes 10 do not have to be formed at the molded resin 8. Thus, extra space for the threaded holes 10 is not needed in the molded resin 8, and therefore the semiconductor module 7 and the semiconductor device 20 can further be miniaturized. Costs can also be reduced by reducing the amount of resin used for the molded resin 8. Furthermore, miniaturization of the semiconductor module 7 may also enable a reduction in the number of fixing points to the chassis 9. These allow the man-hour cost as well as the component number to be reduced when fixing the semiconductor module 7 onto the chassis 9.

Further, as the semiconductor module 7 is fixed with the screws 11, loads are applied for a long time to the portions around the threaded hole 10. When a load is exerted on the molded resin 8 for a long time, deformations sometimes occur due to creep phenomena. In the present embodiment, because the threaded holes 10 are formed through the control substrate 5 and thus the molded resin 8 is not likely to be exerted to loading. Thus, the molded resin 8 is less likely to be deformed due to creep phenomena, and a reduction in deformation can improve product reliability.

Using epoxy resin for the molded resin 8 better improves heat dissipation properties compared with the usage of the silicon-based gel-like resin. Thus, the heat, generated from the control component 14 mounted on the control substrate 5 is efficiently dissipated via the molded resin 8, which enables the components to be mounted on the control substrate 5 in high densities.

Additionally, when the shield plate 4 is connected to the chassis 9, the heat, generated by the semiconductor element 1 and the components mounted on the control substrate 5, can be transferred away to the chassis 9, which can bring about improvement in heat dissipation properties and in the miniaturization of the semiconductor module 7. Note that in the present embodiment, the shield plate 4 is formed as a solid pattern on the control substrate 5 such that it is exposed from the mold resin 8 so as to make contact with the chassis 9 via the spacer 13.

In addition, the molded resin 8 has a high dielectric withstanding voltage, which enables the installation distances to be short for the components even with different types of power supplies, such as gate signals and gate drive circuits, resulting in the mounting of the components to be of even higher density. Furthermore, in cases of components with small pin pitches such as ICs, it is common for leakage to occur that causes circuit malfunctions, thereby conventionally, requiring these portions to be coated with a coating agent such as HumiSeal ®. In the present embodiment, the molded resin 8 is formed by molding the entire control substrate 5 with resin, which is an insulator, so that even when mounting small-pitched ICs, it is not necessary for them to be coated. Further, reducing pattern distances and mounting small-sized components in a high density lead to a miniaturization of the control substrate 5 and also bring about a miniaturization of the semiconductor module 7.

Furthermore, the use of a wide-bandgap semiconductor element such as SiC or GaN for the semiconductor element 1 enables reduction in power loss and further miniaturization of the chip size (the chip size is, for example, reduced by about one-third), thereby improving the miniaturization of the semiconductor module 7. In addition, because the heat resistance of the semiconductor element 1 also becomes higher, the heat-dissipating component 6 can also be miniaturized, enabling further miniaturization.

Additionally, the noises generated by the semiconductor element 1 switching cause the control substrate 5 and other electronic equipment to malfunction. When a wide-bandgap semiconductor element such as SiC or GaN is used for the semiconductor element 1, the switching noise increases; however, if a solid pattern is formed over the control substrate 5 as the shield plate 4, which electrically connects with the ground 12, the noise can be transferred so that malfunctions of the control substrate 5 and other electronic equipment can be reduced. In the present embodiment, the shield plate 4 is connected to the screws 11 and further connected to the ground 12 via the screws 11 and the chassis 9.

The present embodiment describes, but is not limited to, an example in which the semiconductor module 7 is fixed onto the chassis 9 via the fixing bases 5a by screw-fixing, and the present invention is applicable to a feature so long as the fixing forces onto the chassis 9 are applied to the fixing bases 5a. The applicable feature is, for example, a feature in which the fixing bases 5a themselves fold back to the chassis 9 so as for the fixing bases 5a themselves to be fixed to the chassis 9.

### Industrial Applicability

As described above, the semiconductor module according to the present invention is useful for semiconductor modules in which the control substrate and the semiconductor element are integrally molded with resin.

### Reference Signs List

- 1: semiconductor element
- 2: lead frame (placing frame)
- 3: insulating sheet
- 4: shield plate (solid pattern)
- 5: control substrate
- 5a: fixing bases
- 6: heat-dissipating component
- 7: semiconductor module
- 8: molded resin
- 9: chassis (fixing object)
- 10: threaded holes
- 11: screws
- 12: ground
- 13: spacer
- 14: control component
- 20: semiconductor device

## Claims

1. A semiconductor module comprising:
a semiconductor element;
a placing frame on which the semiconductor element is placed;
a control substrate onto which a control component for controlling the semiconductor element is mounted; and
a molded resin in which the semiconductor element, the placing frame, and the control substrate are integrally molded, wherein
a fixing base exposed from the molded resin is provided on the control substrate for fixing the semiconductor module onto a fixing object.

2. The semiconductor module according to claim 1, wherein
the fixing bases are provided in plurality at least on one side and another side of the molded resin and are exposed from the molded resin.

3. The semiconductor module according to claim 1 or 2, wherein
a threaded hole is formed through the fixing base.

4. The semiconductor module according to any one of claims 1 to 3, wherein
the semiconductor element is a wide-bandgap semiconductor element.

5. The semiconductor module according to any one of claims 1 to 4, wherein
the placing frame is arranged on an opposite surface side of a surface of the control substrate onto which the control component is mounted, wherein
a solid pattern is formed on the opposite surface of a surface of the control substrate onto which the control component is mounted.

6. The semiconductor module according to claim 5, wherein the solid pattern is connected to a ground.

7. A semiconductor device comprising:
the semiconductor module according to any one of claims 1 to 6; and
a metallic chassis as the fixing object, wherein
the molded resin securely contacts the chassis by fixing the semiconductor module onto the chassis.
